## Europäisches Patentamt

## European Patent Office

## Office européen des brevets

(11) Numéro de publication: **0 083 526 B1**

(12) # FASCICULE DE BREVET EUROPEEN

(45) Date de publication du fascicule du brevet:
**13.11.85**

(51) Int. Cl.⁴: **H 01 L 41/22**

(21) Numéro de dépôt: **82402342.8**

(22) Date de dépôt: **21.12.82**

(54) Procédé de fabrication d'un bloc en matériau macromoléculaire piézoélectrique, et bloc obtenu par ledit procédé.

(30) Priorité: **31.12.81 FR 8124560**

(43) Date de publication de la demande:
**13.07.83 Bulletin 83/28**

(45) Mention de la délivrance du brevet:
**13.11.85 Bulletin 85/46**

(84) Etats contractants désignés:
**DE GB IT NL**

(56) Documents cités:
**FR - A - 1 457 291**
**FR - A - 2 325 200**
**GB - A - 1 474 369**
**GB - A - 2 020 483**
**US - A - 3 315 290**

**IEEE PUBLICATION 79CH 1476-1AES Eascon, 1979, Record IEEE Electronics and Aerospace Systems Convention, US J.M. POWERS: "Piezoelectric Polymeran emerging hydrophone technology"**

(73) Titulaire: **THOMSON-CSF, 173, Boulevard Haussmann, F-75379 Paris Cedex 08 (FR)**

(72) Inventeur: **Broussoux, Dominique, THOMSON-CSF SCPI 173, bld Haussmann, F-75379 Paris Cedex 08 (FR)**
Inventeur: **Facoetti, Hugues, THOMSON-CSF SCPI 173, bld Haussmann, F-75379 Paris Cedex 08 (FR)**
Inventeur: **Ravinet, Pierre, THOMSON-CSF SCPI 173, bld Haussmann, F-75379 Paris Cedex 08 (FR)**
Inventeur: **Bernard, Daniel, THOMSON-CSF SCPI 173, bld Haussmann, F-75379 Paris Cedex 08 (FR)**
Inventeur: **Micheron, François, THOMSON-CSF SCPI 173, bld Haussmann, F-75379 Paris Cedex 08 (FR)**

(74) Mandataire: **Wang, Pierre et al, THOMSON-CSF SCPI 173, Bld Haussmann, F-75379 Paris Cedex 08 (FR)**

BUNDESDRUCKEREI BERLIN

## Description

La présente invention se rapporte à la fabrication des polymères et copolymères piézoélectriques se présentant sous la forme de blocs de forte épaisseur.

Les polymères piézoélectriques sont utilisés notamment pour réaliser des transducteurs électromécaniques, tels que les transducteurs émetteurs et récepteurs de rayonnements acoustiques et ultrasonores.

Le mémoire »Piezoelectric Polymer-An emerging hydrophone technology« (IEEE Publication 79 CH 1476-1 AES, EASCON 1979 Record, IEEE Electronics and Aerospace Systems Convention, US, Vol. 3, pages 517—523) décrit un empilement de films minces piézoélectriques en matériau macromoleculaire.

Dans beaucoup d'application, ces matériaux macromoléculaires à orientation polaire sont avantageusement substitués aux céramiques piézoélectriques, car ils bénéficient de plus faibles modules d'Young, d'une moindre masse volumique et d'une impédance caractéristique plus proche de celle des milieux aqueux et biologiques. Les coefficients piézoélectriques sont nettement moins importants que ceux des matériaux céramiques piézoélectriques connus, mais en mettant en oeuvre une polarisation électrique énergique associée le cas échéant à un traitement mécanique préalable, on parvient à des performances globales intéressantes. Un aspect important de l'utilisation des polymères piézoélectriques est leur facilité de mise en oeuvre lorsqu'on a besoin d'éléments transducteurs de grande surface. Il faut également signaler que la mise en forme de tels éléments est aisée, mais les épaisseurs de fabrication les plus courantes restent comprises entre quelques microns et un à deux millimètres.

Le champ électrique polarisateur à développer au sein d'un polymère pour qu'il induise une transformation donnant naissance aux propriétés piézoélectriques, électro-optiques ou pyroélectriques recherchées est compris entre $5.10^7$ et $1,5 \, 10^8$ Volts par mètre.

Il faut donc en général une source de haute tension pour polariser un polymère et s'il s'agit de polariser un échantillon d'un centimètre d'épaisseur en une seule opération, la tension qu'il faut mettre en jeu est de l'ordre du million de volts, ce qui est prohibitif. L'évolution des applications des polymères piézoélectriques vers les structures massives en forme de plaques ou de blocs permet de disposer d'un plus grand nombre de paramètres pour situer convenablement une plage de fréquences de fonctionnement ou pour accroître la sensibilité d'un dispositif de rayonnement vibratoire. Aussi, dès que le dimensionnement optimal d'un transducteur entraîne un choix d'épaisseur de l'ordre du millimètre, on est en présence d'un problème de fabrication dont la solution ne peut pas consister à empile simplement des films de moindre épaisseur. En effet, un volume de matériau solide réalisé par empilage de feuillets n'est pas mécaniquement équivalent au même volume réalisé d'un seul tenant. Il est bien connu qu'un empilement de plaques minces ne résiste pas à la flexion sous charge comme le ferait une plaque massive ayant l'épaisseur de l'empilement. De même, il est également connus que dans un empilement, chaque feuillet peut être considéré comme une source qui rayonne à travers ses voisins et que toute rupture d'impédance entre feuillets peut engendrer des réflexions indésirables et des pertes par dissipation d'énergie.

En vue de pallier les inconvénients énumérés ci-dessous, l'invention se propose d'adapter une technique de fabrication qui a été utilisée pour produire des condensateurs à film plastique dans les configurations »pavé« ou »bobiné aplati«.

L'invention a pour objet un procédé de fabrication de blocs en matériau macromoléculaire piézoélectrique à partir d'un film mince utilisé comme élément d'une structure multicouches, caractérisé en ce qu'il consiste à tailler ledit film en au moins une bande de largeur uniforme, à extraire au moins cette bande d'au moins un dévidoir et à l'enrouler sur un mandrin récepteur de façon à former un enroulement multispires ayant ladite largeur et en ce que la partie de ladite bande déployée entre ledit dévidoir et ledit mandrin est encollée selon l'une au moins de ses faces au moyen d'une solution dudit matériau dans un solvant; l'enroulement est comprimé perpendiculairement à ses spires jusqu'à obtention d'une structure multicouches monolithique et lesdits blocs sont constitués par des portions decoupées dans ledit enroulement, ladite bande ayant été soumise à une polarisation electrique en épaisseur avant d'avoir été encollée.

L'invention à également pour objet un bloc obtenu par le procédé susementionné, notamment celui dans lequel chacune des strates de matériau macromoléculaire piézoélectriques est encadrée par deux métallisations ayant une largeur moindre que ladite largeur et qui affleurent alternativement selon deux faces opposées dudit bloc où sont déposées des métallisations assurant leur interconnexion en deux groupes imbriqués.

L'invention sera mieux comprise au moyen de la description ci-après et des figures annexées, parmi lesquelles:

la figure 1 est une vue isométrique d'un bloc piézoélectrique selon l'invention;

les figures 2 à 4 illustrent le procédé de fabrication du bloc de la figure 1;

les figures 5 et 6 représentent des transducteurs électromécaniques réalisés à partir du bloc de la figure 1;

les figures 7 et 8 illustrent une variante de réalisation permettant de réaliser une structure piézoélectrique adaptée au mode de fonctionnement par flexion;

la figure 9 illustre un mode d'enroulement par-

ticulier faisant appel à deux bandes métallisées;

la figure 10 est une vue en coupe d'un transducteur obtenu à partir de l'enroulement de la figure 9;

la figure 11 est une vue en plan du transducteur de la figure 10;

la figure 12 illustre le procédé de fabrication d'un bloc transducteur de type représenté aux figures 10 et 11;

la figure 13 représente un détail de réalisation du dispositif de la figure 12;

la figure 14 représente en coupe un dispositif de compression permettant d'exercer une pression radiale sur l'enroulement représenté aux figures 2 et 12;

les figures 15 et 16 représentent les polarisations électriques à utiliser pour obtenir une fonctionnement selon le mode de flexion en réponse à une tension excitatrice appliquée à deux bornes.

La présente invention a trait à la fabrication de blocs piézoélectriques à partir de matériaux macromoléculaires qui acquièrent des propriétés piézoélectriques permanentes lorsqu'on leur applique un champ électrique intense. Ce champ vise à aligner leurs moments électriques dipolaires pour obtenir une structure dont les propriétés macroscopiques sont similaires à celles de corps cristallins appartenent à une classe non-centrosymétrique.

Parmi ces matériaux macromoléculaires, on connaît des polymères tels que le polyfluorure de vinylidène (PVF$_2$) et ses copolymères avec le polytétrafluorure d'éthylène (PTFE) ou le polychlorotrifluorure d'éthylène (PcITeFE).

Ces matériaux comprennent également des alliages du polyfluorure de vinylidène avec par exemple le polyméthylmétacrylate (PMMA), ainsi que le polychlorure de vinyle (PVC), le polyfluorure de vinyle (PVF), les polyamides etc.

En dehors de tout traitement électrique de polarisation, une lamelle de ces matériaux ne recèle pas de propriétés piézoélectriques. Comme ces matériaux sont d'excellents isolants électriques, une lamelle peut être polarisée en épaisseur en métallisant deux faces opposées et en les reliant à une source de haute tension continue.

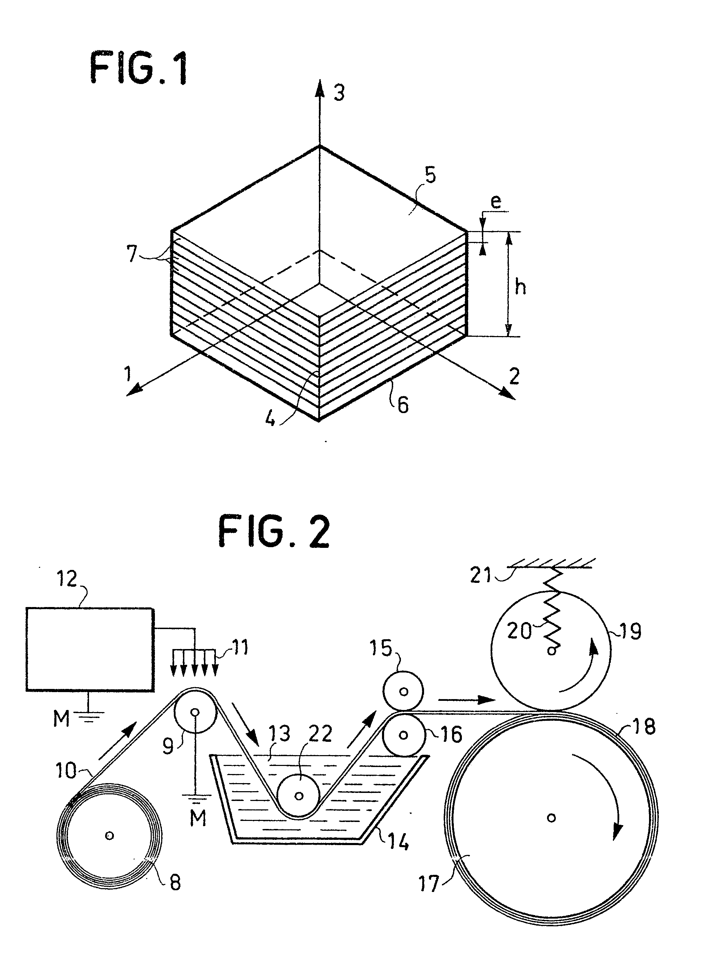

Sur la figure 1, on peut voir un bloc 4 de polymère piézoélectrique fabriqué conformément à la présente invention. A titre d'exemple non limitatif, on a représenté une forme parallélipipédique rapportée à un système d'axes cristallographiques 1, 2, 3. Comme on le verra dans la suite de la description, ce bloc 4 est une structure monolithique obtenue par collage de feuillets 7 d'épaisseur e empilés sur une hauteur h. Les faces 5 et 6 perpendiculaires à l'axe 3 sont généralement métallisées pour obtenir un élément transducteur électromécanique vibrant en mode d'épaisseur lorsqu'on applique une tension alternative entre les métallisations. Inversement, si le bloc de la figure 1 est soumis à une compression alternée agissant perpendiculairement aux faces 5 et 6, on observe l'apparition de charges électriques de signes contraires qui peuvent créer un courant de conduction dans un circuit électrique extérieur ou, lors d'un fonctionnement en circuit ouvert, une différence de potentiel alternative entre faces 5 et 6. Ces effets piézoélectriques direct et inverse résultent d'une orientation permantente des moments dipolaires existant au sein des matériaux macromoléculaires précités. Une telle orientation s'obtient au moyen d'une champ électrique très intense nécessitant la mise en oeuvre d'une tension de polarisation de forte valeur. Comme il s'agit de matériaux dont la structure intime est très difficile à décrire, l'étude des propriétés piézoélectriques fait largement appel à l'expérimentation. En confrontant les sollicitations mécaniques appliquées et les charges électriques induites, il est possible d'assimiler les matériaux macromoléculaires dotés de propriétés piézoélectriques à des matériaux cristillins connus. Ainsi, il est d'usage de mesurer les coefficients piézoélectriques $d_{31}$, $d_{32}$, $d_{33}$, $d_{24}$ et $d_{15}$ des matériaux macromoléculaires comme on le ferait pour des cristaux appartenant aux classes cristallographiques non-centrosymétriques.

L'acquisition des propriétés piézoélectriques par un matériau macromoléculaire est plus ou moins facilitée par le choix d'une composition à structure polaire, par une action mécanique d'étirement servant à convertir une phase non polaire en phase polaire ou par un traitement de polarisation électrique effectueé à une température supérieure à la température ambiante. Néanmoins, par rapport aux cristaux et aux céramiques piézoélectriques, les coefficients piézoélectriques obtenus sont en général beaucoup plus faibles, même si la polarisation électrique à été appliquée avec le maximum d'intensité compatible avec le risque de claquage ou de contournement.

Heureusement, les matériaux macromoléculaires piézoélectriques ont des caractéristiques qui les rendent aptes à de nombreuses applications car ils possèdent de beaucoup plus faibles modules d'Young, une masse spécifique faible et une impédance acoustique plus proche de celle des milieux aqueux et biologiques.

Un exemple typique d'application et celle d'un transducteur électromécanique destiné à convertir un rayonnement ultrasonore incident en tension électrique. La sensibilité s d'un tel transducteur peut s'exprimer par la relation suivante:

$$s = \frac{d}{\varepsilon} \cdot h \cdot G$$

où s est exprimée en volt par Pascal, d est le coefficient piézoélectriques concerné, $\varepsilon$ la constante diélectrique apparente, h l'épaisseur totale du bloc transducteur et G un facteur qui dépend de la géométrie du transducteur et de la fréquence ultrasonore. Ce type de relation se rencontre par exemple dans le cas d'hydrophones utilisant une plaque piézoélectrique plane libre sur ses bords où le facteur G est voisin de l'unité, mais aussi dans le cas de microphones à plaque piézoélectrique encastrée à sa périphérie dans lesquels l'épaisseur h détermine la fréquence de résonance du premier mode d'oscillation en flexion.

Le facteur de mérite M d'un hydrophone est la mesure de l'énergie électrique convertie lorsqu'il est soumis à une pression d'un Pascal.

On a donc:

$$M = \frac{1}{2} CV^2$$

où C est la capacité électrique de la cellule et V la tension électrique pour un Pascal.

Si l'on fait G = 1, on voit que l'on peut mettre le facteur de mérite sous la forme:

$$M = \frac{1}{2} \cdot \frac{d^2}{\varepsilon} \cdot h \cdot S$$

où S est la surface du bloc subissant la pression.

La surface S est fixée en fonction de la directivité angulaire du transducteur, de sorte que c'est le paramètre h qui doit être accru pour augmenter le facteur de mérite. Le fonctionnement en mode d'épaisseur avec deux faces libres impose que l'épaisseur h soit égale à $\lambda/2$ et cette épaisseur peut être réduite de moitié avec une face bloquée. Pour un transducteur en polyfluorure de vinylidène dans lequel le son se propage avec une vitesse de 2000 m/s, on voit qu'une fréquence de fonctionnement de 1 MHz impose une épaisseur h de 0,5 à 1 mm.

Le problème de la polarisation électrique intense d'une plaque de polymère ayant l'épaisseur qui vient d'être mentionnée ou une épaisseur plus forte est délicat à double titre. Le champ électrique de polarisation à créer au sein de la plaque est de l'ordre de 1 MV/cm et il faut mettre en oeuvre une source à haute tension voire à très haute tension qui pose des problèmes specifique de sécurité et de protection contre les disruptures par claquage ou contournement. Il faut aussi que la polarisation soit homogène, ce qui est difficile à obtenir en milieu épais à cause de gradients de champ qui peuvent s'installer du fait de l'injection de charges par les électrodes ou de séparation de charges au sein du diélectrique.

Dans un autre ordre d'idées, l'augmentation d'épaisseur d'une plaque en polymère piézoélectrique tend à accroître l'impédance électrique mesurée entre des métallisations recouvrant ses faces. Lorsqu'un transducteur électromécanique est utilisé en moteur, le générateur électrique d'excitation doit fournir une tension relativement élevée, ce qui nécessite fréquemment un transformateur élévateur de tension entre le transducteur et son circuit d'alimentation en énergie électrique. Ce cas se présente notamment dans les applications électroacoustiques où la tension en ligne est relativement basse. Il est donc souhaitable de disposer de blocs transducteurs épais dans lesquels un champ électrique intense puisse être créé avec une faible tension excitatrice, ceci constituant un deuxième aspect de l'invention.

Pour obtenir une structure monolithique du type représenté sur la figure 1, l'invention s'est inspirée d'une technique de fabrication de condensateurs qui consiste à former un enroulement épais à partir d'un film mince. Le découpage ou l'écrasement de cet enroulement conduisant à des composants du type »bobiné aplati« ou du type »pavé«.

Sur la figure 2, on peut voir une illustration du procédé de fabrication selon l'invention permettant d'obtenir des blocs piézoélectriques entièrement diélectriques.

Ces blocs sont fabriqués à partir d'un film mince 10 d'épaisseur uniforme disponible sur une bobine débitrice 8. Le film 10 est réalisé dans le matériau macromoléculaire choisi, par exemple le polyfluorure de vinylidène. Son épaisseur e peut être comprise entre 6 et 30 microns afin qu'il soit facile à polariser. Initialement, le film 10 peut être dans une phase cristalline $\alpha$ susceptible de transiter vers une phase $\alpha$ p lors de la polarisation électrique ultérieure. Il peut aussi avoir été préétiré mécaniquement suivant une ou deux directions dans son plan, afin de présenter une phase cristalline $\beta$ propice à la polarisation électrique ultérieure. Dans le cas d'un film monoétiré, le produit obtenu présente des coefficients $d_{31}$ et $d_{32}$ inégaux. Dans le cas d'un film biétiré ou non étiré, les coefficients $d_{31}$ et $d_{32}$ sont égaux. Les faces du film 10 sont dépourvues de métallisations, mais selon une variante de réalisation décrite ultérieurement de telles métallisations sont prévues.

Le film 10 déroulé de la bobine débitrice 8 forme une bande diélectrique de largeur constante que l'on enroule sur un mandrin 17 en spires superposées de façon à obtenir un enroulement 18 multispires à flancs alignés. Pour obtenir une structure monolithique, la portion de film comprise entre la bobine 8 et le mandrin 17 subit une opération d'encollage préalable à son enroulement. A cet effet, le dispositif de la figure 2 comporte un train de rouleaux 9, 22, 15 et 16 forçant le film à plonger dans une cuve d'encollage 14 qui contient une solution 13. Cette solution sert à enduire l'une au moins des faces du film 10 afin de servir ultérieurement d'agent de liaison entre spires de l'enroulement 18. La solution 13 est confectionnée à partir d'un solvant du matériau macromoléculaire constituant le film 10 auquel on a incorporé ce même matériau. Ceci permet d'obtenir un dosage précis de l'agressivité de la solution 13 vis à vis du film 10 et après constitution de l'enroulement 18 et évaporation complète du solvant on obtient une structure monolithique dont le liant se fond avec les strates ce qui supprime tout changement d'impédance mécanique au sein de bloc fabriqué. L'attaque contrôlée du film 10 par la solution d'enduction 13 assure une parfaite cohésion des spires de sorte que tous les types de contraintes mécaniques sont transmis sans glissement de celles-ci. A titre d'exemple non limitatif, pour un film de polyfluorure de vinylidène, la solution 13 sera faite de dimethyl formamide dans lequel on aura incorporé une quantité de polyfluorure de vinylidène telle que seule la région superficielle des faces du film 10 soit attaqué par le solvant.

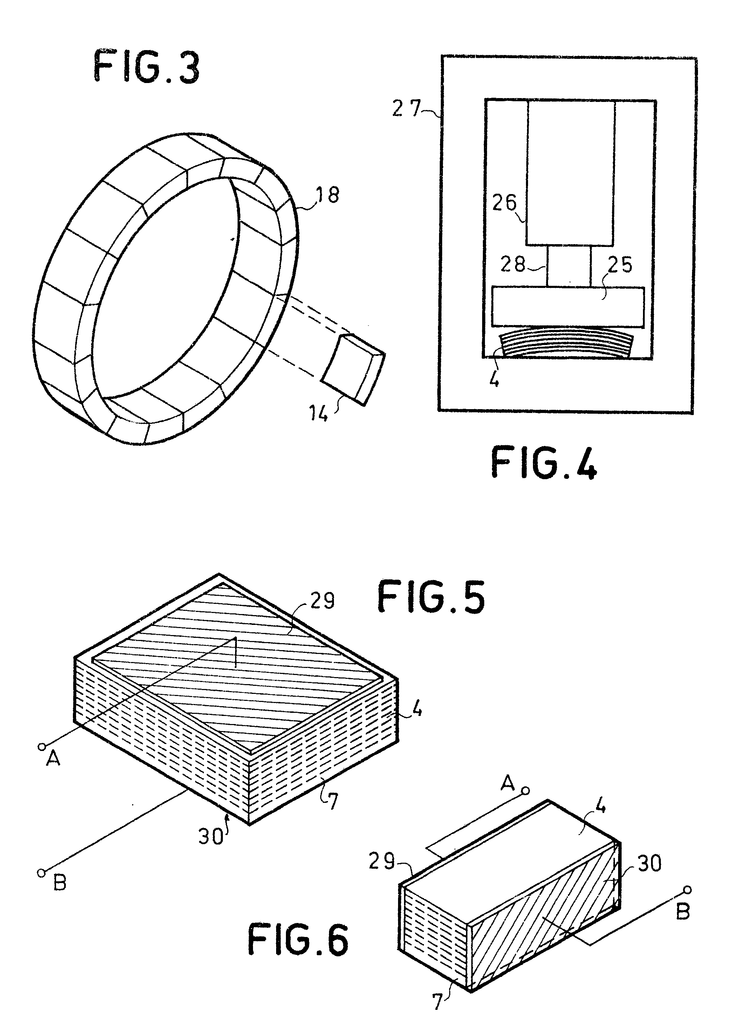

L'opération d'encollage qui vient d'être décrite est suivie du collage proprement dit qui peut avoir lieu sur le mandrin 17 ou après démontage dans une presse telle que représentée à la figure 4. Lorsque le collage est réalisé sur le mandrin 17, l'enroulement 18 est comprimé par un rouleau 19 comme illustré sur la figure 2. L'axe du rouleau 19 est soumis à la poussée radiale d'un ressort 20 dont la compression est ajustée par le déplacement d'une butée 21. Pour éviter tout plissement des spires de l'enroulement 18, le mandrin 17 et le rouleau 19 sont animés de mouvements contrarotatifs qui sont commandés des organes moteurs et de transmission non représentés sur la figure. Le mandrin 17 peut sans inconvénient comporter des méplats pour obtenir une enroulement 18 à configuration polygonale. La poussée du rouleau 18 peut être appliquée pendant le phase d'enroulement ou après que l'enroulement 18 soit achevé et isolé par une coupe du film 10. Ce calandrage en place peut se faire en augmentant la vitesse de rotation du mandrin 17.

Le montage représenté sur la figure 2 illustre en amont de la cuve d'encollage 13 un agencement de moyens permettant d'assurer la polarisation électrique du film 10 lorsque ce dernier n'est pas initialement piézoélectrique. Cet agencement comprend par exemple un rouleau métallique 9 relié à la masse M d'un générateur de tension électrique 12. Un ensemble d'électrodes à pointes 11 est relié au générateur 12 et placé à proximité de la partie du film 10 portée par le rouleau 9, afin de produire une décharge CORONA destinée à rendre le film 10 piézoélectrique. Comme le film 10 est beaucoup plus mince que l'enroulement auquel il va donner naissance, cette disposition est avantageuse, car le tension de polarisation peut être beaucoup plus basse que celle qu'il faudrait mettre en oeuvre pour polariser l'enroulement d'un seul tenant.

A titre d'exemple non limitatif, la polarisation du film 10 pour des épaisseurs comprises entre 6 et 30 µm nécessiterait une tension de décharge CORONA comprise entre 10 et 25 kV. En utilisant un rouleau 9 non chauffé, une vitesse de défilement de 10 cm/minute est appropriée pour obtenir l'orientation dipolaire désirée. Cette vitesse peut être doublée si le rouleau 9 est chauffé à 80°C. Le système d'électrodes 11 peut être disposé à une distance d'environ 2 cm du film 10. Les charges électriques déposées sur le film 10 peuvent être neutralisées lorsque le film plonge dans la solution 13. La solution peut être chauffée à 70°C. La conductivité de la solution 13 établit un court-circuit entre les faces du film 10 de sorte que les charges de surface sont éliminées. Les rouleaux 15 et 16 assurent un dépôt homogène de la solution 13 avec retour à la cuve 14 de tout excédent d'adhésif.

Les moyens de polarisation électrique représentés sur la figure 2 peuvent également consister en un laminoir conçu pour laminer sous champ électrique le film 10. Le laminage peut aussi être remplacé par un simple calandrage sous champ électrique, mais par rapport à ce cas la technique de la décharge CORONA est plus simple à mettre en oeuvre. Il est à remarquer que les moyens de polarisation n'ont pas à être rassemblés dans une même unité de fabrication avec les moyens d'encollage et de formation de l'enroulement 18. En réalisant séparément la polarisation électrique, on peut effectuer l'enroulement avec une vitesse de défilement accrue.

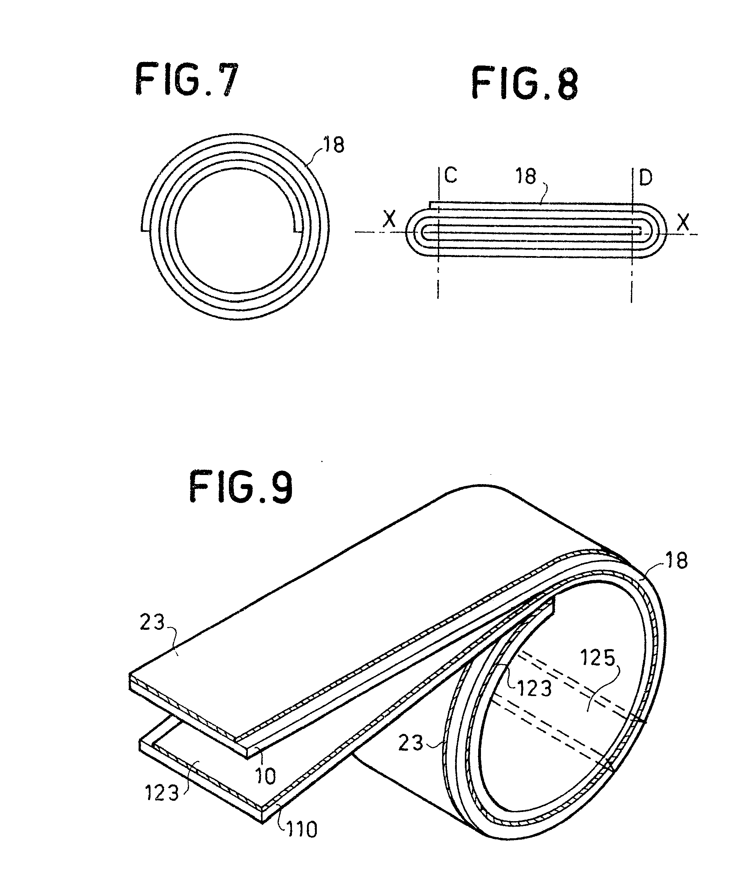

Plusieurs possibilités sont offertes après enroulement du film 10 pour obtenir un ou plusieurs blocs piézoélectriques terminés. Suivant l'une des variantes possibles, l'enroulement 18 est démonté du mandrin lorsque les spires sont complètement rendues solidaires les unes des autres. On obtient ainsi la couronne 18 de la figure 3 qui peut être débitée en morceaux 14. On peut également procéder au démontage et au débitage de l'enroulement 18 avant évaporation complète du solvant et placer les blocs 4 dont les feuillets peuvent encore glisser les uns par rapport aux autres dans la presse représentée à la figure 4. Cette presse comporte un bati 27, un cylindre 26, un piston 28 et un plateau 25 qui coopèrent pour aplanir ou mettre en forme le bloc 4 issu de l'enroulement 18. Une autre possibilité de pressage est illustrée sur les figures 7 et 8. Dans ce cas l'enroulement 18 est conservé entier et pressé pour obtenir le bobinage aplati de la figure 8. Les parties repliées sont ensuite éliminées par deux coupes C et D. Le bloc piézoélectrique obtenu par la technique illustrée aux figures 3 et 4 possède une polarisation homogène dans toute son épaisseur à condition que la polarisation du film 10 soit faite uniformément au fur et à mesure de la constitution de l'enroulement. La bloc piézoélectrique obtenu par la technique illustrée aux figures 7 et 8 présente des polarisations homogènes et de signes contraires de part et d'autre du plan médian de trace XX. Il s'agit donc d'une structure bimorphe apte à fléchir sous l'action d'un champ électrique excitateur unidirectionnel perpendiculaire au plan d'écrasement XX.

Les blocs obtenus par le procédé qui vient d'être décrit sont diélectriques dans la masse et polarisés transversalement par rapport aux feuillets 7 qui les composent. Pour réaliser un transducteur électromécanique, on encadre un tel bloc par une ou plusieurs paires d'électrodes. Cet encadrement peut se faire comme illustré sur la figure 5 en recouvrant les faces parallèles aux feuillets 7 par des électrodes 29 et 30 reliées à deux bornes A et B. Les déformations sont alors déterminées par le coefficients piézoélectriques $d_{31}$, $d_{32}$ et $d_{33}$. L'encadrement peut également se faire comme illustré sur la figure 6 en recouvrant deux faces perpendiculaires aux feuillets 7. Dans ce cas, les déformations sont régies par les coefficients piézoélectriques de cisaillement $d_{24}$ et $d_{15}$.

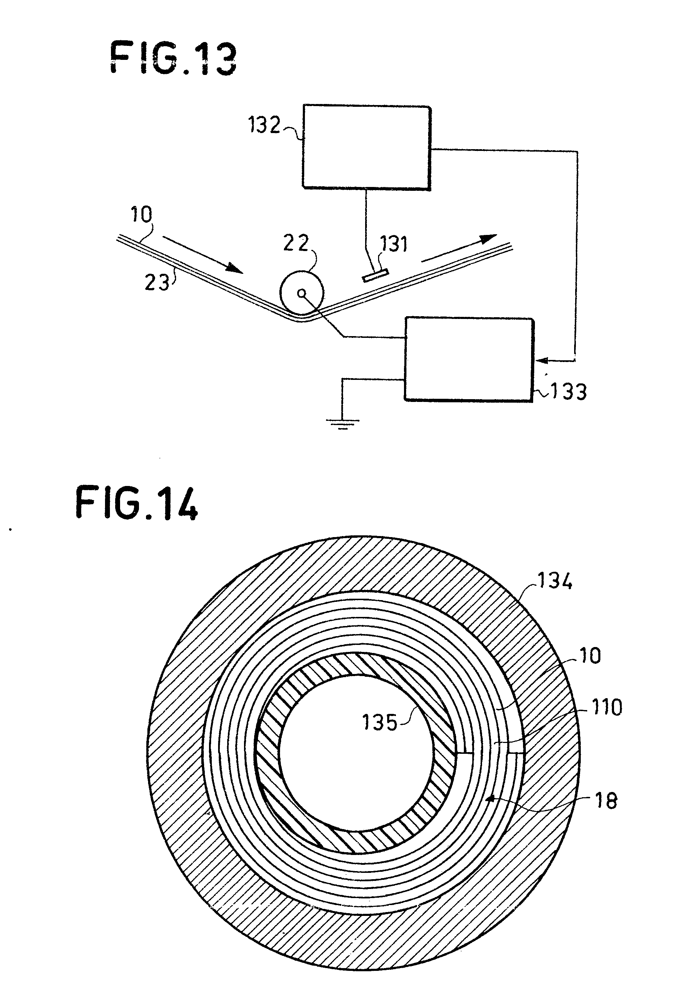

Bien entendu, l'invention n'est pas limitée au cas de l'enroulement d'un seul fim 10. On peut parfaitement prévoir plusieurs bobines débitrices 8 et former l'enroulement 18 en enroulant plusieurs films 10 provenant de ces bobines. De même, le découpage selon des plans de coupe méridiens tel qu'illustré sur la figure 3 peut être complété par des coupes ayant d'autres orientations, par exemple perpendiculaire à l'axe d'enroulement. Les blocs réalisés conformément à l'invention peuvent avoir des formes très variées puisque la seule condition imposée est d'avoir deux facettes équidistantes qui peuvent être planes, cintrées ou bombées selon les modalités de pressage. La conservation de la forme annulaire de l'enroulement n'est pas exclue, car on peut réaliser des transducteurs électromécaniques à structure tubulaire. Le pressage d'un enroulement de forme annulaire est illustré sur la figure 14 où l'on voit que l'enroulement 18 est monté entre une enveloppe élastique 135 et une enveloppe cylindrique rigide 134. En exerçant une pression interne sur l'enveloppe 135, on peut comprimer radialement l'enroulement 18 contre l'enveloppe rigide 134.

Dans de nombreuses applications, il est souhaitable de disposer de transducteurs électromécaniques à basse impédance, car les circuits électriques amplificateurs à semiconducteurs sont limités en tension. On peut obtenir ce type de caractéristique en rapprochant le plus possible les électrodes. Dans les blocs piézoélectriques formés d'un empilage de feuillets, la distance la plus courte entre électrodes correspond à l'épaisseur e d'un feuillet qui n'est que le $n^{ième}$ partie de l'épaisseur totale h du bloc. A effet piézoélectrique égal, on peut donc diviser par n la tension excitatrice en prévoyant une électrode à chaque interface entre deux feuillets. Dans ce cas, les électrodes sont constituées par des métallisations très légères qui affectent peu les caractéristiques mécaniques du bloc piézoélectrique ; elles sont reliées entre elles par des métallisations latérales, comme cela est prévu dans le cadre de la fabrication des condensateurs multicouches.

Sur la figure 9, on peut voir une vue isométrique d'un enroulement 18 destiné à confectionner des transducteurs à basse impédance. L'enroulement 18 est composé de deux films piézoélectriques 10 et 110 auxquels sont associées des métallisations 23 et 123 qui, après bobinage, séparent l'un de l'autre les films 10 et 110. Sur la figure 9, les métallisations 23 et 123 portés respectivement par les films 10 et 110, mais on pourrait aussi bien prévoir l'enroulement d'un film dépourvu de métallisations avec un autre film métallisé sur ses deux faces. Un point important est de faire en sorte que les métallisations 23 et 123 couvrent la surface des films à l'exception d'une marge située de chaque côté de l'enroulement comme illustré sur la figure 9. L'autre point important est de polariser électriquement le film 10 en sens contraire du film 110, afin que les effets piézoélectriques résultant d'une tension excitatrice appliquée aux métallisations 23 et 123 soient généralement concordants.

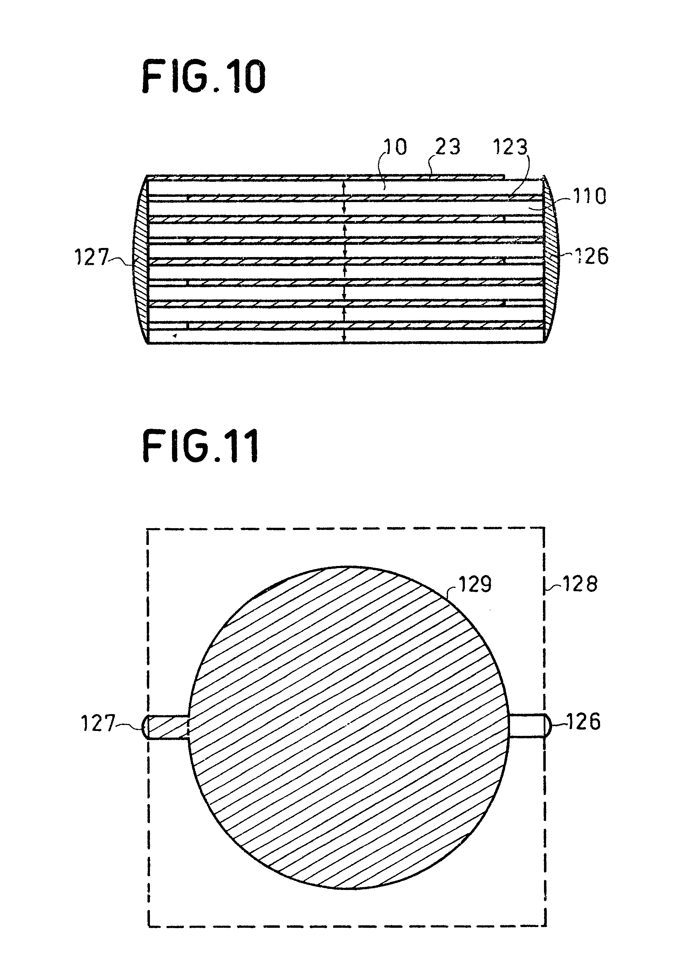

La figure 10 repésente une coupe méridienne de l'enroulement 18 de la figure 9. Les films 10 et 110 alternent ainsi que les flèches qui matérialisent le sens de la polarisation électrique dans chaque couche. Les métallisations 23 affleurent à gauche de l'enroulement où elles sont réunies électriquement par une métallisation latérale 127. Les métallisations 123 affleurent à droite et sont réunies par une métallisation latérale 126. Lorsque la structure de la figure 10 est excitée par une tension appliquée aux métallisations 127 et 126, les déformations des films 10 et 110 sont concordantes de sorte que globalement le mode vibratoire est le même que celui du dispositif de la figure 5, mais nécessite une tension n fois moins grande, n étant le nombre total de films empilés.

La figure 11 est une vue en plan d'un bloc 125 découpé hors de l'enroulement 18 de la figure 9. Ce premier découpage aboutit à une forme à contour rectangulaire 128, mais on peut effectuer ensuite une découpe supplémentaire par exemple de forme circulaire avec deux pattes qui rejoignent les bords de la découpe initiale. La forme 129 est excitée électriquement par des métallisations 127 et 126 qui recouvrent les extrémités des deux pattes de connexion. La limitation des métallisations 127 et 126 telle qu'illustrée sur la figure 11 évite que le périmètre 129 de la structure vibrante soit raidie inutilement.

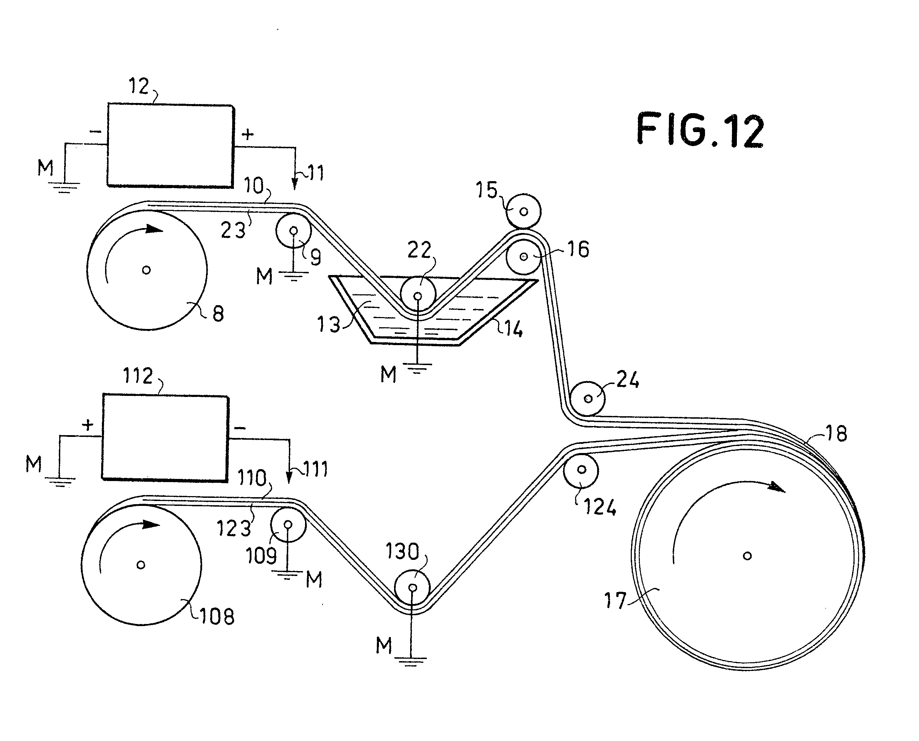

La figure 12 illustre le procédé de fabrication d'un bloc piézoélectrique comportant des métallisations internes à interconnexion latérale.

Deux films minces 10 et 110 de matériau macromoléculaire sont déroulés à partir de bobines débitrices 8 et 108. Ces films ont la même épaisseur e et sont garnis de métallisations 23 et 123 agencées comme illustré sur la figure 9, mais placées par exemple sur les faces inférieures. Le film 10 est porté par un rouleau 9 relié à la masse M d'un générateur électrique 12. Une électrode CORONA reliée au pôle positif du générateur 12 surplombe la face nue du film 10 et sert à le polariser transversalement dans une première direction. Le film 10 porteur de la métallisation 23 est ensuite encollé par une solution 13 contenue dans la cuve 14. Un rouleau 22 relié à la masse M assure l'immersion du film composite 10—23 et la neutralisation des charges libres créées par la décharge CORONA. Des rouleaux 15 et 16 assurent d'uniformité d'encolage du film composite qui après passage par un rouleau de renvoi atteint le mandrin 17 où il est enroulé conjointement avec l'autre film composite 110—123. Le film composite 110—123 est polarisé électriquement par une électrode CORONA 111 reliée au pôle négatif du générateur électrique 112. Cette électrode 111 surplombe le film 110—123 à l'endroit où il passe sur le rouleau métallique 109 relié à la masse M. Le film 110—123 est polarisé dans une seconde direction opposée la direction de polarisation du film 10–23. Un rouleau métallique 130 relié à la masse M sert à éliminer les charges électriques des surface qui ont été déposées par la polarisation électrique. Le film 110–123 quitte le rouleau 130 pour s'enrouler conjointement avec le film 10–23; à cet effet un rouleau de guidage 124 est prévu à proximité du rouleau 24, afin que les deux films se présentent dans de bonnes conditions de superposition. En effet, il faut éviter que les flancs annulaires de l'enroulement 18 présentent un aspect déchiqueté. On peut éviter cet invonvénient en émargeant les films à une largeur prédéterminée et en munissant le mandrin 17 de joues amovibles

Sur la figure 13, on peut voir un détail de réalisation du dispositif de la figure 2 permettant d'assurer l'élimination des charges de surface déposées lors de la polarisation. Le rouleau 22 est relié à un générateur électrique 133 créant entre celui-ci et la masse une différence de potentiel ajustable. Le champ électrostatique à proximité de la partie du film 10 qui quitte le rouleau 22 est mesuré à l'aide d'une électrode 131 reliée à un électromètre 132. Une boucle de rétro-action relie la sortie de l'électromètre 132 à l'entrée qui commande la variation de la différence de potentiel produite par le générateur 133. Cette boucle est conçue pour neutraliser les charges électriques que pourrait transporter le film 10 jusqu'au mandrin 17. Cette neutralisation est plus sûre qu'une simple mise à la terre et elle sert à empêcher la captation des poussières entre le rouleau 22 et le mandrin d'enroulement 17.

A titre d'exemple non limitatif, l'installation représentée sur la figure 12 permet avec une vitesse de défilement linéaire de 10 cm/minute d'obtenir des films enroulés de PVF$_2$ ayant des coefficients piézoélectriques $d_{33} = 13pCN^{-1}$ et $d_{31} = D_{32} \simeq 10pCN^{-1}$. Ceci concerne des films préalablement biétirés présentant 40% de phase $\beta$. Avec des films monoétirés de même concentration en phase $\beta$, les coefficients piézoélectriques $d_{33}$ et $d_{31}$ peuvent être plus élevés alors que le coefficient piézoélectrique $d_{32}$ est compris entre 10 et 20% de $d_{31}$.

La vitesse de défilement sous les pointes CORONA peut être sensiblement augmentée en effectuant la polarisation à chaud. A cet effet, différents moyens peuvent être envisagés: chauffage par air chaud, par pertes diélectrique ou par conduction en chauffant par exemple à 80°C les rouleaux 9 et 109. La vitesse de défilement peut être double et les coefficients piézoélectriques sont accrus de 20 à 50%. Comme pour le dispositif de la figure 2, l'encollage des films sera effectué avec une solution 13 faite par exemple de diméthyl formamide (DMF) saturée de PVF$_2$. On pourra aussi dissoudre dans le solvant DMF un copolymère à forte concentration en PVF$_2$ ($\geq 70\%$) ou un alliage avec PMMA. La solution 13 sera avantageusement chauffée à 80°C pour favoriser un début d'attaque de la surface du film 10 par dissolution. L'enroulement sur le tambour moteur 17 pourra également se faire à chaud ainsi que la compression de l'enroulement sous une pression de plusieurs centaines de kilogrammes par centimètre carré et à une température de l'ordre de 60°C.

Le pressage effectué après démontage de l'enroulement dans une presse telle que celles représentées aux figures 4 et 14 présente l'avantage de ne faire subir qu'une seule chauffe globale de l'élément d'enroulement alors que le pressage in situ sur le mandrin 17 fait que les premières couches enroulées sont chauffées plus longtemps que les dernières. Etant donné que chaque élévation de température tend à dépolariser légèrement les films, il y a risque d'inhomogénéité de coefficient piézoélectrique dans l'épaisseur h du bloc, source de flexion indésirable.

Lorsque l'enroulement est achevé, il rest à effectuer les prises de contact avec les métallisations internes. A cet effet, les métallisations 23 et 123 qui affleurent sur les flancs de l'enroulement 18 sont réunies électriquement en projetant sur les flancs un métal par projection à chaud. Si les métallisations portées par les films 10 et 110 sont obtenues par évaporation d'aluminium, le métal de garnissage des flancs de l'enroulement 18 pourra être l'aluminium. Il est à noter que le garnissage des flancs de l'enroulement avec le métal d'interconnexion peut se faire avant ou après découpage de l'enroulement 18. Au lieu d'utiliser un métal comme moyen d'interconnexion des métallisations 23 et 123, on peut utiliser une colle conductrice. L'argenture à froid ou à chaud est également un moyen efficace permettant de réaliser les interconnexions. Tout ce qui a été décrit précédemment peut s'appliquer à des films de grande largeur. Les fabricants de films en matériaux macromoléculaires polarisables fournissent ces films dans les largeurs courantes 30, 140 et 300 cm.

Jusqu'ici, on a supposé que la polarisation électrique des films présente un caractère uniforme qui se conserve d'un bout à l'autre de l'enroulement. On peut cependant modifier l'amplitude ou le signe des tensions de polarisation en cours l'enroulement.

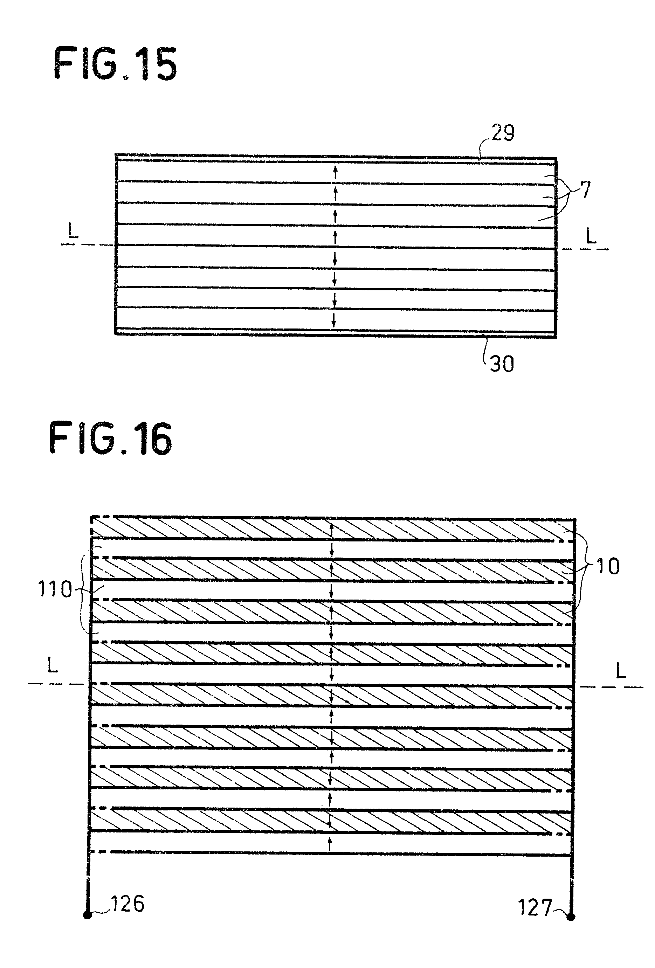

La figure 15 représente en coupe un bloc piézoélectrique obtenue par le procédé mettant en oeuvre le dispositif de la figure 2 à ceci près que le signe de la tension de polarisation a été inversé au moment où l'enroulement des spires 7 a atteint la hauteur marquée par la ligne LL. Il en résulte, comme le montrent les flèches de la figure 15, que les feuillets 7 en dessous de la ligne LL sont tous polarisés de haut en bas. Par contre, les feuillets 7 situés au-dessus de la ligne LL sont tous polarisés de bas en haut.

Lorsqu'on excite le bloc de la figure 15 au moyen d'un tension alternative appliquée aux électrodes externes 29 et 30, la partie située au-dessus de la ligne LL se déforme en opposition de phase par rapport à la partie située au-dessous de cette ligne. Un tel élément piézoélectrique constitue une structure bimorphe dont la déformation résultante est une flexion alternée.

Pour obtenir un comportement analogue avec un bloc piézoélectrique fabriqué au moyen du dispositif représenté sur la figure 12, il y a lieu de réaliser l'enroulement en partie avec les polarités représentées sur cette figure et de permuter ces polarités pour terminer l'enroulement. La figure 1 représente un élément piézoélectrique fabriqué selon cette technique.

Les flèches montrent une alternance de polarisation des films 10 et 110 qui subit une inversion de phase lorsqu'on franchit la ligne LL qui représente la fibre neutre d'un transducteur bimorphe. Avantageusement, la ligne LL se situe à mi-hauteur de l'enroulement pour obtenir une flexion alternée symétrique.

Bien entendu, on peut aussi jouer sur l'amplitude de la polarisation pour privilégier l'effet piézoélectrique dans certains feuillets, par exemple les feuillets extérieurs qui en flexion subissent des allongements plus importants que les feuillets proches de la fibre neutre LL.

L'invention n'est pas limitée à des structures stratifiées dans lesquelles les électrodes internes ou externes sont constituées par des métallisations. On peut également obtenir les électrodes de garnissage du film avant enroulement en réalisant l'encollage avec une solution enrichie de particules conductrices, carbone par exemple. Dans ce cas, la nécessité de laisser subsister des marges de chaque côté de la bande à encoller entraîne une modification des processus d'encollage. En l'occurence, il ne faut pas immerger le film polymère dans la solution conductrice, mais le faire passer entre deux rouleaux ayant été convenablement encollés, les largeurs d'encollage étant décalées pour assurer le transfert de la colle sur une partie seulement de la largeur de la bande. Les métallisations externes situées sur les faces de l'enroulement afin de réunir les électrodes intersticielles peuvent aussi être remplacées par des dépôts de polymère chargé de particules conductrices.

**Revendications**

1. Procédé de fabrication de blocs en matériau macromoléculaire piézoélectrique à partir d'un film mince utilisé comme élément d'une structure multicouche, caractérisé en ce qu'il consiste:

- à tailler ledit film en au moins une bande (10) de largeur uniforme,
- à extraire au moins ladite bande (10) d'au moins un dévidoir (8) et à l'enrouler sur un mandrin récepteur (17) de façon à former un enroulement multispires (18) ayant ladite largeur,
- et en ce que la partie de ladite bande (10) déployée entre ledit dévidoir (8) et ladit mandrin (17) est encollée selon l'une au moins de ses faces au moyen d'une solution (13) dudit matériau dans un solvant,

- l'enroulement (18) est comprimé perpendiculairement à ses spires jusqu'à obtention d'une structure multicouche monolithique et
- lesdits blocs (4) sont constitués par des portions découpées dans ledit enroulement (18), ladite bande (10) ayant été soumise à une polarisation électrique en épaisseur avant d'avoir été encollée.

2. Procédé selon la revendication 1, caractérisé en ce que ladite polarisation électrique en épaisseur est effectuée après extraction de ladite bande (10) dudit dévidoir (8).

3. Procédé selon l'une quelconque des revendications 1 et 2, caractérisé en ce que deux bandes (10, 110) sont extraites de deux dévidoirs (8, 108) et enroulées simultanément sur un mandrin récepteur (17); l'une au moins desdites bandes étant encollée de façon à disposer d'un agent de liaison entre lesdites bandes, lorsqu'elles sont superposées dans ledit enroulement (18).

4. Procédé selon la revendiation 3, caractérisé en ce que l'agent de liaison est rendu électriquement conducteur en incorporant à la solution d'encollage (13) des particules conductrices.

5. Procédé selon la revendication 4, caractérisé en ce que les particules conductrices sont des particules de carbone.

6. Procédé selon la revendication 3, caractérisé en ce que les bandes (10, 110) sont munies de métallisations (23, 123) encadrant chacune des spires de l'enroulement (18); ces métallisations occupant une partie de la largeur de l'enroulement et affleurant respectivement sur ses deux faces latérales.

7. Procédé selon l'une quelconque des revendications 4 à 6, caractérisé en ce que des dépôts conducteurs (126, 127) sont effectués sur les faces latérales dudit enroulement (18).

8. Procédé selon la revendication 7, caractérisé en ce que lesdits dépôts conducteurs (126, 127) sont constitués par des métallisations.

9. Procédé selon la revendication 8, caractérisé en ce que lesdits dépôts conducteurs (126, 127) sont constitués par un matériau polymère chargé de particules conductrices.

10. Procédé selon l'une quelconque des revendications 1 et 2, caractérisé en ce que la polarisation électrique en épaisseur est de même signe pour toute la hauteur d'enroulement (18).

11. Procédé selon l'une quelconque des revendications 1 et 2, caractérisé en ce que la polarisation électrique en épaisseur est de même signe dans une première portion d'enroulement (18) et de signe contraire dans une seconde portion d'enroulement (18).

12. Procédé selon l'une quelconque des revendications 1 à 7, caractérisé en ce que la polarisation électrique en épaisseur est alternée sur toute la hauteur de l'enroulement (18).

13. Procédé selon l'une quelconque des revendications 1 à 7, caractérisé en ce que la polarisation électrique en épaisseur est alternée dans deux portions contigues de la hauteur de l'enroulement (18); l'alternance changeant de signe en passant de l'une à l'autre desdites portions.

14. Procédé selon l'une quelconque des revendications précédentes, caractérisé en ce que la polarisation électrique en épaisseur est obtenue au moyen d'une décharge CORONA.

15. Procédé selon l'une quelconque des revendications précédentes, caractérisé en ce que l'intensité de la polarisation électrique en épaisseur est modulée en cours du déroulement de ladite bande (10, 110).

16. Procédé selon l'une quelconque des revendications précédentes, caractérisé en ce que la compression de l'enroulement (18) comporte une opération de mise en forme dans une presse.

17. Procédé selon la revendication 16, caractérisé en ce que l'opération de mise en forme est effectuée après avoir retiré l'enroulement précomprimé dudit mandrin (17).

18. Procédé selon la revendication 17, caractérisé en ce que l'opération de mise en forme porte sur les portions détachées dudit enroulement (18).

19. Procédé selon la revendication 17, caractérisé en ce que l'opération de mise en forme porte sur la totalité dudit enroulement (18).

20. Procédé selon la revendication 19, caractérisé en ce que l'opération de mise en forme met en œuvre un moyen de pressage (135) agissant radialement sur ledit enroulement (18).

21. Procédé selon la revendication 19, caractérisé en ce que l'opération de mise en forme confère à l'enroulement (18) une forme aplatie.


**Patentansprüche**

1. Verfahren zur Herstellung von Blöcken aus piezoelektrischem makromolekularen Material aus einem dünnen Film, der als Element einer mehrschichtigen Struktur verwendet wird, dadurch gekennzeichnet, daß es darin besteht, daß:

— der genannte Film in wenigstens einen Streifen (10) von gleichmäßiger Breite geschnitten wird,

— wenigstens der genannte Streifen (10) von wenigstens einem Abwickler (8) abgezogen und auf einem Aufnahmedorn (17) derart aufgewickelt wird, daß eine Wicklung (18) in mehreren Windungen mit der genannten Breite gebildet wird,

— und daß derjenige Teil des Streifens (10), der zwischen dem Abwickler (8) und dem genannten Dorn (17) ausgebreitet ist, auf wenigstens einer seiner Flächen mittels einer Lösung (13) des genannten Materials in einem Lösungsmittel haftbeschichtet wird,

— die Wicklung (18) senkrecht zu ihren Windungen zusammengedrückt wird bis eine monolithische mehrschichtige Struktur erhalten wird, und

— die genannten Blöcke (4) durch von der genannten Wicklung (18) abgeschnittene Teile gebildet werden, wobei der genannte Streifen (10) einer elektrischen Polarisation durch die Dicke ausgesetzt wurde, bevor er haftbeschichtet wurde.

2. Verfahren nach Anspruch 1, dadurch gekennzeichnet, das die genannte elektrische Polarisation in der Dicke nach Abziehen des genannten Streifens (10) von dem genannten Abwickler (8) erfolgt.

3. Verfahren nach Anspruch 1 oder 2, dadurch gekennzeichnet, daß die Streifen (10, 110) von zwei Abwicklern (8, 108) abgezogen und gleichzeitig auf einem Aufnahmedorn (17) aufgewickelt werden; wobei wenigstens einer der Streifen haftbeschichtet wird, so daß über ein Verbindungsmittel zwischen den genannten Streifen verfügt wird, wenn sie in der genannten Wicklung (18) einander überlagert werden.

4. Verfahren nach Anspruch 3, dadurch gekennzeichet, das das Verbindungsmittel elektrisch leitfähig gemacht wird, indem leitende Teilchen in die Haftmittellösung (13) eingearbeitet werden.

5. Verfahren nach Anspruch 4, dadurch gekennzeichnet, das die leitfähigen Teilchen Kohlenstoffteilchen sind.

6. Verfahren nach Anspruch 3, dadurch gekennzeichnet, daß die Streifen (10, 110) mit Metallisierungen (23, 123) versehen werden, welche jede der Windungen der Wicklung (18) einrahmen; wobei diese Metallisierungen einen Teil der Breite der Wicklung einnehmen und jeweils in eine der zwei Seitenflächen einmünden.

7. Verfahren nach einem der Ansprüche 4 bis 6, dadurch gekennzeichnet daß leitfähige Ablagerungen (126, 127) auf den seitlichen Flächen der genannten Wicklung (18) aufgebracht werden.

8. Verfahren nach Anspruch 7, dadurch gekennzeichnet, daß die genannten leitfähigen Ablagerungen (126, 127) aus Metallisierungen gebildet werden.

9. Verfahren nach Anspruch 8, dadurch gekennzeichnet, daß die genannten leitfähigen Ablagerungen (126, 127) aus einem polymeren Material gebildet werden, in das leitfähige Teilchen eingearbeitet sind.

10. Verfahren nach einem der Ansprüche 1 und 2, dadurch gekennzeichnet, daß die elektrische Polarisation in der Dicke über die gesamte Höhe der Wicklung (18) dasselbe Vorzeichen aufweist.

11. Verfahren nach einem der Ansprüche 1 und 2, dadurch gekennzeichnet, daß die elektrische Polarisation in der Dicke in einem ersten Teil der Wicklung (18) dasselbe Vorzeichen und in einem zweiten Teil der Wicklung (18) das entgegengesetzte Vorzeichen aufweist.

12. Verfahren nach einem der Ansprüche 3 bis 7, dadurch gekennzeichnet, daß die elektrische Polarisation in der Dicke über die gesamte Höhe der Wicklung (18) alterniert.

13. Verfahren nach einem der Ansprüche 3 bis 7, dadurch gekennzeichnet, daß die elektrische Polarisation in der Dicke in zwei aneinanderangrenzenden Teilen der Höhe der Wicklung (18) abwechselt; wobei die Wechselfolge von einem Teil zum anderen einen Vorzeichenwechsel aufweist.

14. Verfahren nach einem der vorstehenden Ansprüche, dadurch gekennzeichnet, daß die elektrische Polarisation in der Dicke durch eine Corona-Entladung erhalten wird.

15. Verfahren nach einem der vorstehenden Ansprüche, dadurch gekennzeichnet, daß die Stärke der elektrischen Polarisation in der Dicke im Verlauf des Abwickelns des genannten Streifens (10, 110) moduliert wird.

16. Verfahren nach einem der vorstehenden Ansprüche, dadurch gekennzeichnet, daß das Zusammendrücken der Wicklung (18) zugleich mit einer Formgebung in einer Presse erfolgt.

17. Verfahren nach Anspruch 16, dadurch gekennzeichnet, daß die Formgebung erfolgt, nachdem die vorkomprimierte Wicklung von dem Dorn (17) abgenommen wurde.

18. Verfahren nach Anspruch 17, dadurch gekennzeichnet, daß die Formgebung auf die losgelösten Teile der genannten Wicklung (18) angewendet wird.

19. Verfahren nach Anspruch 17, dadurch gekennzeichnet, daß die Formgebung auf die Gesamtheit der genannten Wicklung (18) angewendet wird.

20. Verfahren nach Anspruch 19, dadurch gekennzeichnet, daß die Formgebung unter Anwendung einer Preßeinrichtung (135) erfolgt, welche radial auf die genannte Wicklung (18) einwirkt.

21. Verfahren nach Anspruch 19, dadurch gekennzeichnet, daß die Formgebung der Wicklung (18) eine abgeflachte Form erteilt.

## Claims

1. Method of producing blocks of piezoelectric macromolecular material from a thin foil used as element of a multilayer structure, characterized in that it consists:

— in cutting said foil into at least one strip (10) of uniform width,
— in withdrawing at least said strip (10) from at least one payoff device (8) and winding it about a receiving mandrel (17) in a manner to form a multi-winding coil (18) having said width,
— and in that the exposed portion of said strip (10) between said payoff device (8) and said mandrel (17) is coated on a least one of its faces with a solution (13) of said material in a solvent,
— the coil (18) is compressed perpendicularly to its wendings until a mutilayer monolithic structure is obtained and,
— said blocks (4) are formed of portions sectioned from said coil (18), said strip (10) having been exposed to an electric polarization in thickness prior to having been coated.

2. Method according to claim 1, characterized in that said electric polarization in thickness is performed after the withdrawing of said strip (10) from said payoff device (8).

3. Method according to any of claims 1 and 2, characterized in that two strips (10, 110) are withdrawn from two payoff devices (8, 108) and simultaneously wound about a receiving mandrel (17); at least one of said strips being coated in a manner to provide a connection means between said strips when they are superimposed in said coil (18).

4. Method according to claim 3, characterized in that the connection means is rendered electrically conductive by incorporating conductive particles into the adhesive solution (13).

5. Method according to claim 4, characterized in that the conductive particles are carbon particles.

6. Method according to claim 3, characterized in that the strips (10, 110) are provided with metallizations (23, 123) framing each of the windings of the coil (18); these metallizations occupying a portion of the width of the coil and extending to its lateral faces, respectively.

7. Method according to any of claims 4 to 6, characterized in that metallic deposits (126, 127) are formed on the lateral faces of said coil (18).

8. Method according to claim 7, characterized in that said conductive deposits (126, 217) are formed by metallizations.

9. Method according to claim 8, characterized in that said conductive deposits (126, 127) are formed of a polymer material loaded with conductive particles.

10. Method according to any of claims 1 and 2, characterized in that the electric polarization in thickness has the same sign across the entire height of the coil (18).

11. Method according to any of claims 1 and 2, characterized in that the electric polarization in thickness has the same sign in a first portion of the coil (18) and the opposite sign in a second portion of the coil (18).

12. Method according to any of claims 3 to 7, characterized in that the electric polarization in thickness alternates across the entire height of the coil (18).

13. Method according to any of claims 3 to 7, characterized in that the electric polarization in thickness alternates in two adjacent portions of the height of the coil (18); the alternating arrangement having changing signs from one to the other of said portions.

14. Method according to any of the preceding claims, characterized in that the electric polarization in thickness is obtained by means of a Corona discharge.

15. Method according to any of the preceding claims, characterized in that the intensity of the electric polarization in thickness is modulated while said strip (10, 110) is paid off.

16. Method according to any of the preceding claims, characterized in that the compression of the coil (18) comprises a shaping step in a press.

17. Method according to claim 16, characterized in that the shaping step is performed after having removed the precompressed coil from said mandrel (17).

18. Method according to claim 17, characterized in that the shaping step is carried out with the loose portions of said coil (18).

19. Method according to claim 17, characterized in that the shaping step is carried out with the entire coil (18).

20. Method according to claim 19, characterized in that the shaping step includes the use of pressing means (135) radially acting upon said coil (18).

21. Method according to claim 19, characterized in that the shaping step forms the coil (18) into a flattened shape.

# FIG.1

# FIG. 2

# FIG.3

18

14

# FIG.4

27
26
28
25
4

# FIG.5

29
A
B
30
7
4

# FIG.6

A
29
4
30
7
B

# FIG.7

# FIG.8

18

C    18    D

X ———————————————— X

# FIG.9

23

18

125

123

10

123

110

23

# FIG.10

# FIG.11

FIG.12

# FIG.13

# FIG.14

# FIG.15

# FIG.16